Europäisches Patentamt

European Patent Office

Office européen des brevets

(11) Publication number: **0 054 455**
**B1**

(12) **EUROPEAN PATENT SPECIFICATION**

(45) Date of publication of patent specification: **26.09.84**

(51) Int. Cl.³: **H 04 N 3/15, H 01 L 27/14**

(21) Application number: **81401836.2**

(22) Date of filing: **20.11.81**

(54) Method for driving a charge injection device.

(30) Priority: **27.11.80 JP 167828/80**

(43) Date of publication of application:
**23.06.82 Bulletin 82/25**

(45) Publication of the grant of the patent:
**26.09.84 Bulletin 84/39**

(84) Designated Contracting States:
**DE FR GB**

(56) References cited:
**US-A-3 935 446**

**IEEE JOURNAL OF SOLID STATE CIRCUITS,
voi. SC-11, no. 1, February 1976, NEW YORK
(US), H.K. BURKE et al.: "Charge-injection
imaging: operating techniques and
performances characteristics", pages 121-128**

(73) Proprietor: **FUJITSU LIMITED
1015, Kamikodanaka Nakahara-ku
Kawasaki-shi Kanagawa 211 (JP)**

(72) Inventor: **Hiroyuki, Ishizaki
13-14, Takaoka 6-Chome
Okubo-cho Akashi-shi Hyogo 674 (JP)**
Inventor: **Yoshiki, Tsujino
684-38-7A-307, Yamanoue Hiraoka-cho
Kakogawa-shi Hyogo 675-01 (JP)**
Inventor: **Masaji,. Dohi
8-9, Tsurukabuto 4-Chome
Nada-ku Kobe-shi Hyogo 654 (JP)**

(74) Representative: **Descourtieux, Philippe et al
CABINET BEAU de LOMENIE 55 rue
d'Amsterdam
F-75008 Paris (FR)**

Courier Press, Leamington Spa, England.

## Description

The present invention relates to an improved method for driving a charge-injection device (hereinafter referred to as CID) which is used as image sensing device for bi-dimensional images.

A CID is known as a solid state imaging device which reads out corresponding electrical image signals by sensing the optical radiation pattern.

More particularly, the present invention relates to a method for driving a CID where the picture imaging elements consisting of storing electrodes (2Y) and detecting electrodes (2X) are arranged in the form of a matrix on a semiconductor substrate, the storing electrodes (2Y) of the picture elements are connected in common for each column (or row), the detecting electrodes (2X) are connected in common for each row (or column) and the basic operation sequence essentially containing each operation of charge storing in a first period ($T_0$), readout in a period ($T_1$) and injection in a period ($T_3$) is sequentially applied for each picture element which is considered as the read-out element with a constant time delay.

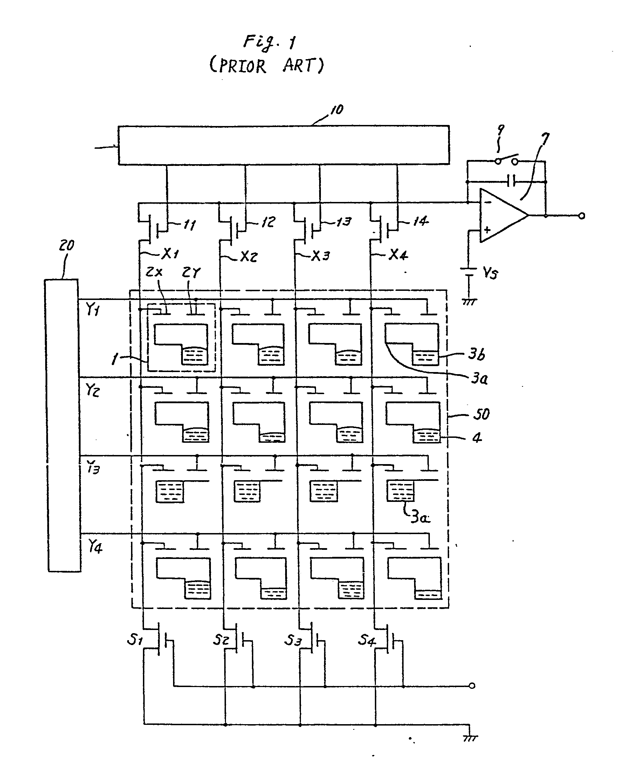

A method of this type is disclosed by H. K. Burke et al in "I.E.E.E Journal of Solid State Circuits", Vol. SC-11, No. 1, Feb. 1976, pp. 121—128. This prior art is illustrated by the enclosed Fig. 1. On this Figure, a CID is shown comprising picture elements 1 each of which is composed of a pair of insulating electrodes 2X and 2Y arranged bi-dimensionally on the semiconductor substrate which is covered with an insulating film at its surface, and the electrodes 2X of each row are connected in common to the vertical X buses $X_1$ to $X_4$ while the other electrodes 2Y of each column are connected in common to the horizontal Y buses $Y_1$ to $Y_4$. When an optical image is projected onto the sensing surface 50 of such matrix under the condition that a voltage of about 10V is applied to one electrode 2X of picture elements and a voltage of about 20V to the other electrode 2Y, the charges 4 in the semiconductor substrate generated by the optical activation are stored in the potential well 3b formed just under the electrode 2Y. Thereafter, said charges 4 are shifted at a time for each picture element to the well 3a just under the adjacent electrode 2X at such a timing that the wells just under the electrode 2Y connected to the selected Y bus have disappeared during the voltage operation from the shift register 20 in the vertical direction. The condition during such process can be seen in the picture element group of 3rd stage in Fig. 1. The image charge is generated on the electrode 2X at the moment when such charge 4 is shifted, and said image charge is sequentially read out to the output terminal of the charges sensitive amplifier 7 via the electronic switches 11, 12, 13, 14. Here, 10 is the horizontal shift register; 9 is the reset switch which applies a voltage $V_S$ to the electrode 2X of each picture element; $X_1$ to $X_4$, $Y_1$ to $Y_4$ are X bus group and Y bus group, respectively.

When readout for one frame of said CID is completed, the well 3a to which the charges generated by optical activation are shifted can disappear by turning ON the electronic switches $S_1$ to $S_4$. Thus, said charges are injected into the substrate and disappear therein. Now, the succeeding charges generated by optical activation are stored in the well newly formed just under the electrode 2Y preparing for the image sensing of the next frame.

Here, said insulated electrode 2Y has the function of storing signal charges and therefore it is called the storing electrode while the electrode 2X has the function of detecting signal charges and therefore it is called the detecting electrode.

In the case of the abovementioned CID, the peripheral circuits as well as the charge sensitive amplifier 7 can be integrated on the same substrate. However, the upper limit of frequency response of such charge sensitive amplifier 7 is usually set to a frequency as low as 1 MHz and it means that it is difficult to read out the signal within a period shorter than 1 $\mu$sec. Therefore, it is impossible to employ a high speed drive with the structure shown in Fig. 1 for a CID where many picture elements are arranged with high density.

It is enough, for solving such problem, to sequentially read out in parallel all signals, in the sequence of columns, for example, sent from the picture elements arranged in a line in the vertical direction, but it is always accompanied by considerable difficulty to inject all picture element charges to the substrate after completing parallel read-out in the sequence of columns and store the optically activated charges by immediately preparing a new well. In other words, in case the life time of charges injected into the substrate is comparatively long such as 1 $\mu$ sec, for example, if the next storing operation is started while the charges injected first into the substrate have not yet disappeared and remain, such remaining charges partly enter the newly formed well (this is called the so-called cross-talk phenomenon), drastically degrading the read-out image.

In order to solve such crosstalk problem, it is considered to prepare the sufficient idle time needed for the disappearance of injected charges after the stored charges of all picture elements are injected into the substrate. Thereby the crosstalk can be prevented perfectly but, as a result the frame time becomes longer due to the setting of the idle time, thus making it difficult to effect a high speed operation.

It is an object of the present invention to solve the abovementioned problem which is caused by the injected charges.

It is another object of the present invention to provide a new method for driving a CID which can successfully solve the problem of residual image and deterioration of resolution resulting from the charges injected.

It is a further object of the present invention to provide a method for driving the CID which has achieved a high speed sequential read-out without any crosstalk.

It is yet a further object to provide a high speed drive method for the CID which ensures high quality image signals.

These objects are attained by means of a method of the type defined at the beginning of this description, said method being characterized in that, according to the present invention, the basic operation sequence is modified whereby after each read-out period $(T_1)$ the charge packet is transferred back to a charge well beneath the storing electrode (2Y) for a predetermined charge holding period $(T_2)$ immediately prior to the respective injection period $(T_3)$ and the sequential application of said modified operation sequence is controlled so as to reduce the effect of crosstalk between adjacent imaging elements upon the injection of the charge into the CID substrate during said injection period $(T_3)$.

Figure 1 explains the general structure and operation of the CID belonging to the prior art.

Figure 2 is a block diagram indicating the circuit structure of a parallel read-out type CID according to a preferred embodiment of the present invention.

Figure 3 shows the principal part of the timing chart to explain the method for driving a CID according to the present invention.

Figure 4 shows the entire part of a timing chart explaining the CID drive method according to the present invention.

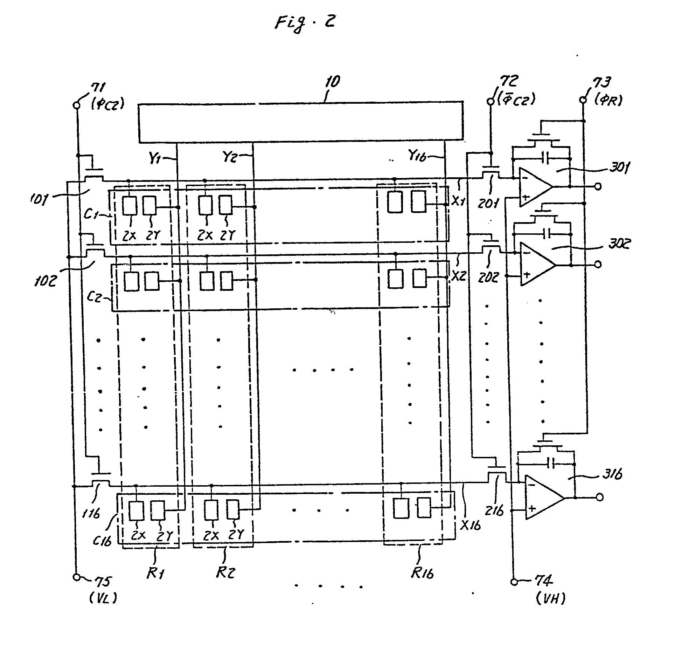

Figure 2 shows the circuit structure of the CID suitable for the present invention, with a CID of 16×16 picture elements parallel read-out type wherein the charge sensitive amplifiers 301 to 316 are connected respectively to the horizontal buses $X_1$ to $X_{16}$ in view of achieving a high speed read-out operation. In the case of this parallel read-out operation, a picture element group of one vertical column enclosed by dotted lines in Fig. 2 is called a vertical picture element column $R_1$ to $R_{16}$, while a picture element group enclosed by broken lines for one horizontal column is called an horizontal picture element column $C_1$ to $C_{16}$.

In the parallel read-out type CID where the wiring is as shown in Fig. 2, vertical shift registers are not used but a 1st group of electronic switches 101 to 116 and a 2nd group of electronic switches 201 to 216 are provided in place of such shift registers. In addition, a pulse $\phi c_2$ is applied to the common gate terminal 71 of the 1st group of electronic switches and on the other hand, a pulse $\bar{\phi}c_2$, namely the reverse phase pulse of $\phi c_2$ is applied to the common gate terminal 72 of the 2nd group of electronic switches. Additionally, a power source $V_H$ is connected to the terminal 74 for biasing the detecting electrode 2X via the charge sensitive amplifiers. When the pulse $\bar{\phi}c_2$, reaches the high level H, the pulse $\phi c_2$ simultaneously reaches the low level L. Therefore, the high level voltage $V_H$ supplied from the terminal 74 biases the detecting electrode 2X of each picture element via the input terminals of the charge sensitive amplifiers 301 to 316 and the electronic switches 201 to 216 in the ON condition and a comparatively shallow well is formed thereunder. On the contrary, when the pulse $\phi c_2$ reaches the high level H and the pulse $\bar{\phi}c_2$ reaches the L level, the electronic switches 101 to 116 are turned ON, while the electronic switches 201 to 216 are turned OFF. As a result, the horizontal buses $X_1$ to $X_{16}$ are disconnected from the charge sensitive amplifiers 301 to 316, and simultaneously connected, in turn, to the low level (or ground potential) of terminal 75. Therefore, each detecting electrode 2X is biased to a low level voltage and the well just under the said electrode 2X disappears.

On the other hand, a drive voltage having a predetermined waveform is sequentially applied selectively to the storing electrodes 2Y in the vertical picture element columns $R_1$ to $R_{16}$ toward the direction from the bus $Y_1$ to $Y_{16}$ via the vertical buses $Y_1$ to $Y_{16}$ from the shift register 10 in such a manner that the storing period and readout period, charge sustaining period and injection period are set as explained later. In this case, the deep well formed previously just under the storing electrode 2Y disappears once in the readout period, the signal charges generated therein are shifted to the shallow well formed just under the detecting electrode 2X, said signal charges are read by the charge sensitive amplifiers 301 to 316 via the horizontal buses $X_1$ to $X_{16}$, the electronic switches 201 and 216 being turned ON, and such signal charges are outputted in parallel to the output terminal of each charge sensitive amplifier.

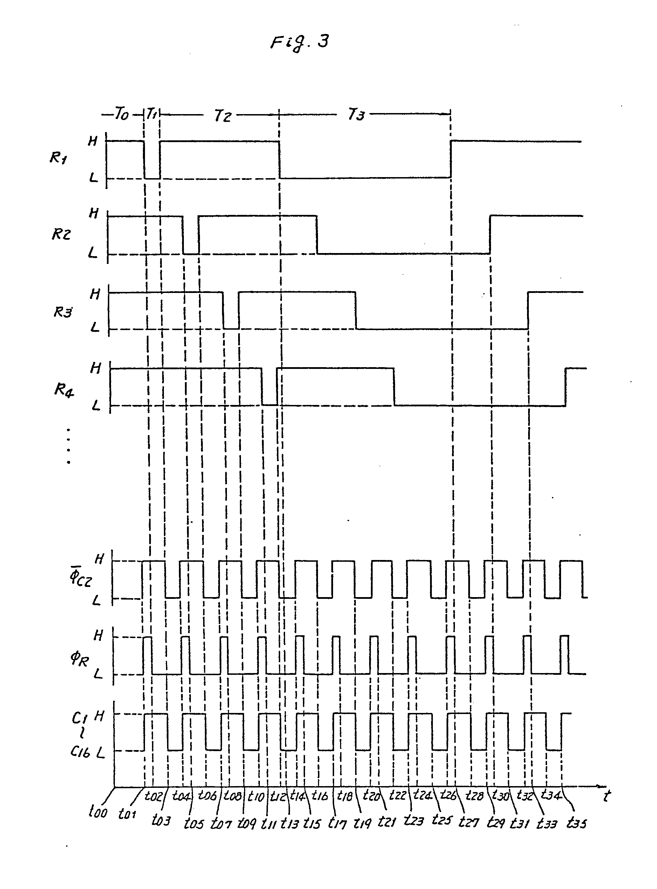

Figure 3 shows an enlarged part of the signal charge readout timing chart (explained later) of the CID having the structure shown in Fig. 2; the operation mode of the vertical picture element columns $R_1$, $R_2$, $R_3$, $R_4$ ... is the operation sequence composed of a charge storing period $T_0$, a readout period $T_1$, a charge holding period $T_2$, and an injected period $T_3$. Namely, the storing electrode 2Y of the 1st picture element column $R_1$ is set to the high level potential H and operates in the storing mode during the period from $t_{00}$ to $t_{02}$, set to the low level potential L and carries out transfer of signal charge to the well in the side of detecting electrode 2X and resultant readout of it during the period from $t_{02}$ to $t_{03}$, set to the high level H again and fetches again the signal charges and sustains them during the period from $t_{03}$ to $t_{13}$, and finally set again to the low level L and injects the charges into the substrate during the period from $t_{13}$ to $t_{27}$. Both high and low levels of each voltage waveform shown in Fig. 3 as $R_1$ to $R_4$ show the levels of voltages applied sequentially to the storing electrode 2Y of the corresponding vertical picture element columns from the shift register 10.

Here, the 1st vertical picture element column $R_1$ is considered. A high level H voltage is applied to the detecting electrode 2X of the horizontal picture element columns $C_1$ to $C_{16}$ from the terminal 74 as shown in $C_1$ to $C_{16}$ of Fig. 3 at the timing $t_{01}$ just before the voltage at the storing electrode 2Y drops to the low level L thus the shallow well is formed just under said detecting electrode, waiting to transfer the charges from the deep well formed just under the storing electrode 2Y. In case the voltage of the storing electrode 2Y of the vertical picture element column $R_1$ drops to the low level at the time $t_{02}$ and the well just under the storing electrode 2Y disappears, the shallow well just under the detecting electrode 2X of the pertinent picture element column receives the signal charges from the deep well. However, since the image charges are generated on the detecting electrode, said image charges are detected by the charge sensitive amplifier, thus completing the readout operation.

Succeedingly, the voltage of storing electrode 2Y of the vertical picture element column $R_1$ becomes H level again in the charge holding period from $t_{03}$ to $t_{13}$ and the charges which were once transferred to the detecting electrode 2X are returned again to the well formed under the pertinent storing electrode 2Y, setting the holding condition; in this case, the reason why the holding period is provided will be explained later. However, during this charge holding period, since the well is formed just under the storing electrode 2Y, the charges generated by the incident light will be stored but these stored charges are not read out as the signal charges, but injected to the substrate during the injection period from $t_{13}$ to $t_{27}$ and disappear.

Then, the same operation sequence as that explained above is applied to the vertical picture element column $R_2$ with a time difference of $t_{05}-t_{02}$ and the same operation sequence is also applied to the vertical picture element column $R_3$ with a further time difference of $t_{08}-t_{05}$. In the same way, the succeeding vertical picture element columns $R_4, R_5, R_6, R_7, \ldots$ are operated with the same time difference and the same operation sequence as explained above. In Fig. 3, the signal indicated by $\bar{\phi}c_2$ is the waveform for controlling the ON and OFF conditions of the electronic switches 201 to 216, corresponding to the abovementioned voltage waveforms $C_1$ to $C_{16}$ applied to the detecting electrode 2X of each horizontal picture element column. In Fig. 3, the signal indicated by $\phi_R$ is the waveform of the reset pulse for the charge sensitive amplifiers 301 to 316. This signal is changed to high and low levels a little quicker than the readout start time of the vertical picture element columns mentioned above because the charge sensitive amplifiers discharge the charges stored precedingly in the feedback capacitances of said charge sensitive amplifiers before said charge sensitive amplifiers connected to the horizontal picture element columns detect the image charges. In Fig. 3, where the time t is plotted on the horizontal axis, the voltage applied to the horizontal picture element columns $C_1$ to $C_{16}$ are often switched to high and low levels corresponding to $\bar{\phi}c_2$. Thereby, when the vertical picture element column $R_1$ enters the injection mode, for example, at the time $t=t_{13}$, the well is formed just under the detecting electrode 2X if the voltage of the detecting electrode 2X of the horizontal picture element columns $C_1$ to $C_{16}$ is in the high level, and therefore no charge is injected into the substrate. This phenomenon is also true for the other vertical picture element columns $R_2, R_3, R_4, \ldots$ Thus, as shown in Fig. 3, the well is not formed just under the detecting electrode 2X when the voltage of detecting electrode 2X of the horizontal picture element columns $C_1$ to $C_{16}$ at the time $t=t_{12}$ a little before the time $t=t_{13}$ is set to the low level and as a result the used charges can be injected into the substrate as required. This reason also causes the voltage of the detecting electrode 2X of the horizontal picture element columns $C_1$ to $C_{16}$ at the times $t=t_{16}$, $t=t_{19}$ and $t=t_{22}$ to change to the low level. In other words, for the vertical picture element column $R_1$ actual charge injection is carried out in each period of $t_{12}$ to $t_{14}$, $t_{16}$ to $t_{17}$, $t_{19}$ to $t_{20}$, $t_{22}$ to $t_{23}$, $t_{25}$ to $t_{26}$; while for the vertical picture element $R_2$ actual charge injection is carried out in each period of $t_{16}$ to $t_{17}$, $t_{19}$ to $t_{20}$, $t_{22}$ to $t_{23}$, $t_{25}$ to $t_{26}$, $t_{28}$ to $t_{29}$, for the vertical picture element column $R_3$, in each period of $t_{19}$ to $t_{20}$, $t_{22}$ to $t_{23}$, $t_{25}$ to $t_{26}$, $t_{28}$ to $t_{29}$, $t_{31}$ to $t_{32}$ and for the vertical picture element column $R_4$, in each period of $t_{22}$ to $t_{23}$, $t_{25}$ to $t_{26}$, $t_{28}$ to $t_{29}$, $t_{31}$ to $t_{32}$, $t_{34}$ to $t_{35}$.

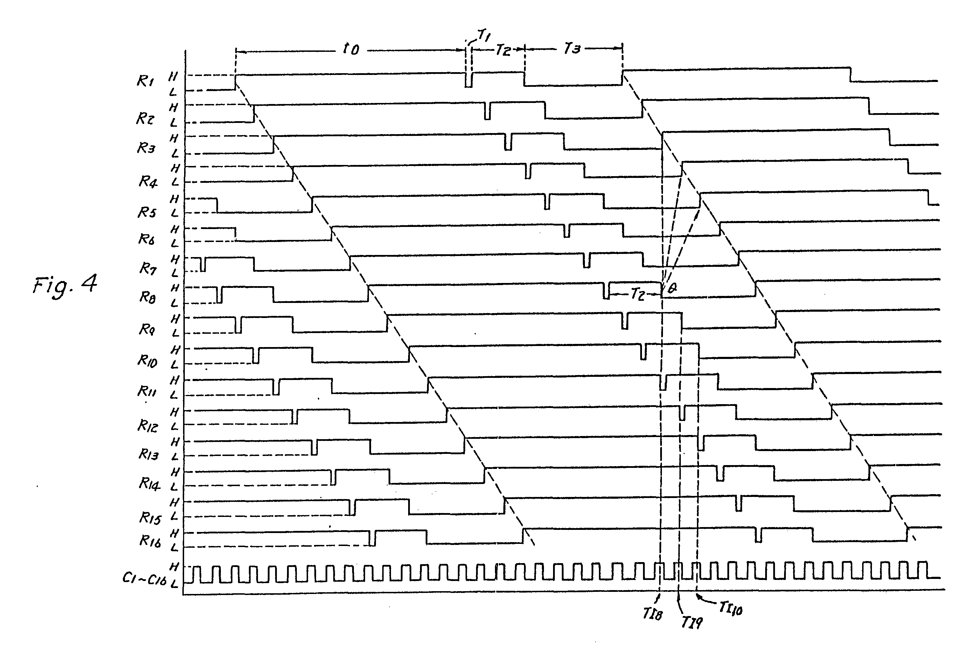

Figure 4 shows the entire part of timing chart of the CID drive of the present invention, and the same portions as Fig. 3 are given the same symbols.

The reason for providing the charge holding time $T_2$ in the present invention will be explained in this timing chart. Here, the attention is focused on the point Q of the 8th vertical picture element column $R_8$ in Fig. 4 where it becomes low level at the timing $t=T_{18}$ and carries out charge injection. Said 8th picture element column $R_8$ carries out charge injection to the substrate at the time of $T_{18}$ and the injected charges could enter a well if a well is formed in the periphery of the 8th picture element column.

However, the 7th picture element column $R_7$ which is nearest to said picture element column $R_8$ the next nearest 6th picture element, and the 5th, 4th picture element columns $R_5, R_4$ are in the low level at the charge injection timing $T_{18}$. Namely, no well is formed under the storing electrodes of the vertical picture element columns from 7th to 4th columns and thereby crosstalk does not occur for said picture element column group.

But, since the voltage of the storing electrode of the 3rd picture element column $R_3$ is switched to the high level at the time $T_{l8}$ and the voltage of storing electrode of the 2nd and 1st picture element columns $R_2$ and $R_1$ is switched to the high level before the time $T_{l8}$, a well is formed under the storing electrodes of the vertical picture element columns $R_1$, $R_2$ and $R_3$ ready to accept the injected charges.

However, the picture element columns from 8th column to 1st, 2nd and 3rd columns are considerably isolated and the injected charges disappear by recoupling before they reach the wells of said 1st, 2nd and 3rd picture element columns $R_1$, $R_2$ and $R_3$ and never migrate into said wells. When attention is focused on the 9th and 10th picture element columns $R_9$ and $R_{10}$, the voltages applied to these picture element columns are at the high level and wells are obviously formed under the storing electrodes. Therefore, the charges injected into the substrate from the 8th picture element at the time $T_{l8}$ flow into the wells just under the storing electrodes formed by said 9th and 10th picture element columns $R_9$ and $R_{10}$. Instead, the charges injected which enter the well under the detecting electrode of the 11th picture element column $R_{11}$ at the time $T_{l8}$ in the readout mode are trapped into the well of the 9th and 10th picture element columns, remaining only a little while and therefore picture quality is not deteriorated.

On the other hand, the injected charge of the 8th picture element columns flows into the wells of the 9th and 10th picture element columns, but since the readout of charges of these wells is completed, if the injected charges partly flow into it, they are injected again to the substrate at the times $T_{l9}$ and $T_{l10}$. As a result, no crosstalk occurs on the readout picture. Since the 11th picture element column $R_{11}$ is substantially spatially isolated from said vertical picture element column $R_8$ via a double well column, it is considered that the charge injected does not flow into the well of the 11th picture element column $R_{11}$ just formed at the time $T_{l8}$. Namely, the influence of injected charges can be minimized by inserting a charge holding period (corresponding to the two picture element column readout period in the case of the figure) which is longer than the time until the readout for the adjacent at least one picture element column terminates between the readout period and injection period.

For example, and in addition, in the 4th and 5th picture element columns, voltages of these picture elements turn to the high level at the times $T_{l9}$, $T_{l10}$ which are delayed from the time $T_{l8}$.

Moreover, these picture element columns $R_4$, $R_5$ are also considerably isolated from the 8th picture element column. Such isolation on timing and distance cause the charges injected from the 8th picture element column to disappear due to re-coupling until they reach the well generated at the timings $T_{l9}$, $T_{l10}$, of the 4th and 5th picture element columns $R_4$, $R_5$. As a result, these charges do not enter said wells, not resulting in crosstalk.

The phenomenon where charges injected migrate into the wells formed in the other picture element columns in the periphery of the picture element column where charges are injected can be prevented by providing the specified charge holding period $T_2$ between the read out period $T_1$ and the injection period $T_3$, and as a result, the crosstalk of signal charges can be suppressed and problems of deteriorating picture quality of read image can be eliminated.

In the above embodiment, the explanation is based on the parallel readout for comprehension purposes. The present invention is not particularly limited to such parallel readout and also shows excellent effects when being adapted to the series readout system.

As explained previously, the readout system for the CID of the present invention ensures readout picture without crosstalk and brings about wide expectations of practical applications because there is no fear of allowing the frame time to become longer.

## Claims

1. Method for driving a solid state-imaging array of the charge injection device (CID) type where the picture imaging elements consisting of storing electrodes (2Y) and detecting electrodes (2X) are arranged in the form of a matrix on a semiconductor substrate, the storing electrodes (2Y) of the picture elements are connected in common for each column (or row), the detecting electrodes (2X) are connected in common for each row (or column) and the basic operation sequence essentially containing each operation of charge storing in a first period ($T_0$), read-out in a period ($T_1$) and injection in a period ($T_3$) is sequentially applied for each picture element which is considered as the read out element with a constant time delay, characterised in that: the basic operation sequence is modified whereby after each readout period ($T_1$) the charge packet is transferred back to a charge well beneath the storing electrode (2Y) for a predetermined charge holding period ($T_2$) immediately prior to the respective injection period ($T_3$) and the sequential application of said modified operation sequence is controlled (Figure 3 and 4) so as to reduce the effect of cross talk between adjacent imaging elements upon the injection of the charge into the CID substrate during said injection period ($T_3$).

2. Method for driving a charge injection device as claimed in claim 1, characterized in that, said charge holding period is longer than the period required for completing readout operations of adjacent at least one readout unit picture element.

3. Method for driving a charge injection device as claimed in claim 1, where the picture element group which is the unit of readout operation is the picture elements in unit of row or column connected in common.

4. Method for driving a charge injection device as claimed in claim 1, where said charge holding period is given at the potential well just under said storing electrode.

5. Method for driving a charge injection device as claimed in claim 3, where the charge sensitive amplifiers are connected corresponding to the row bus connecting in common the detecting electrodes for each row, the operation voltage waveforms consisting of the storing mode, readout mode, charge holding mode and charge injection mode are sequentially applied repeatedly to the column bus connecting in common the storing electrodes for each column, and the signal charges in unit of the column direction picture element array are readout in parallel.

6. Method for driving a charge injection device as claimed in claim 5, where the operation voltage applied to the detecting electrode through said row bus is periodically changed to high and low levels as causing the potential well to disappear just under the pertinent electrode prior to start of charge injection mode for each column bus.

**Revendications**

1. Procédé de commande d'un réseau de formation d'image à l'état solide du type dispositif d'injection de charges (DIC) où des éléments de formation de l'image constitués d'électrodes d'emmagasinage (2Y) et d'électrode de détection (2X) sont disposés sous forme d'une matrice sur un substrat semiconducteur, les électrodes d'emmagasinage (2Y) des éléments de formation de l'image sont connectées en commun pour chaque colonne (ou rangée), les électrodes de détection (2X) sont connectées en commun pour chaque rangée (ou colonne), et la séquence de fonctionnement de base, contenant essentiellement chaque opération d'emmagasinage de charges dans une première période ($T_0$), de lecture dans une période ($T_1$) et d'injection dans une période ($T_3$), est séquentiellement appliquée pour chaque élément d'image qui est considéré comme l'élément lu avec un retard de temps constant, caractérisé en ce que: on modifie la séquence de fonctionnement de base de façon que, après chaque période de lecture ($T_1$), le paquet de charges soit renvoyé dans un puits de charges se trouvant au-dessous de l'électrode d'emmagasinage (2Y) pendant une période prédéterminée ($T_2$) de maintien de charges immédiatement avant la période d'injection ($T_3$) respective, et l'application séquentielle de ladite séquence de fonctionnement modifiée est commandée (figures 3 et 4) de façon à réduire l'effet de la diaphonie entre éléments de formation d'image adjacents lors de l'injection des charges dans le substrat du DIC pendant ladite période d'injection ($T_3$).

2. Procédé de commande d'un dispositif d'injection de charges selon la revendication 1, caractérisé en ce que ladite période de maintien de charges est plus longue que le temps nécessaire pour que soient achevées les opérations de lecture d'au moins un élément d'image de l'unité de lecture adjacente.

3. Procédé de commande d'un dispositif d'injection de charges selon la revendication 1, où le groupe d'éléments d'image qui est l'unité de l'opération de lecture est constitué des éléments d'image formés en unité de rangée ou de colonne et connectés en commun.

4. Procédé de commande d'un dispositif d'injection de charges selon la revendication 1, où ladite période de maintien de charges est donnée au niveau du puits de potentiel se trouvant juste au-dessous de ladite électrode d'emmagasinage.

5. Procédé de commande d'un dispositif d'injection de charges selon la revendication 3, où les amplificateurs sensibles à la charge sont connectés en correspondance avec les bus de rangée connectant en commun les électrodes de détection de chaque rangée, les formes d'onde de tension de fonctionnement, qui sont constituées du mode d'emmagasinage, du mode de lecture, du mode de maintien de charges et du mode d'injection de charges, sont appliquées séquentiellement à répétition aux bus de colonne connectant en commun les électrodes d'emmagasinage de chaque colonne, et les charges de signaux se trouvant dans l'unité de l'ensemble d'éléments d'image suivant la direction des colonnes sont lues en parallèle.

6. Procédé de commande d'un dispositif d'injection de charges selon la revendication 5, où la tension de fonctionnement appliquée à l'électrode de détection par l'intermédiaire dudit bus de rangée varie périodiquement entre le niveau haut et le niveau bas pour amener le puits de potentiel à disparaître juste au-dessous de l'électrode considérée avant le début du mode d'injection de charges pour chaque bus de colonne.

**Patentansprüche**

1. Verfahren zum Betrieb einer Festkörper-Abbildungs-anordnung vom Ladungsinjektionstyp, bei welcher die Abbildungselemente aus speichernden Elektroden (2Y) und fühlenden Elektroden (2X) bestehen, die in Form einer Matrix auf einem Halbleitersubstrat angeordnet sind, die speichendden Elektroden (2Y) der Bildelemente jeder Spalte (oder Reihe) gemeinsam angeschlossen sind, die fühlenden Elektroden (2X) jeder Reihe (oder Spalte) gemeinsam angeschlossen sind unde die Basis-betriebssequenz, die im wesentlichen jeden Betrieb der Ladungsspeicherung während einer ersten Periode (T$_0$), des Auslesens in einer Zeitperiode (T$_1$) und der Injektion in einer Period (T$_3$) umfaßt, sequentiell für jedes Bildelement angewendet wird, das als das Ausleseelement mit einer konstanten Zeitverzöögerung angesehen wird, dadurch gekennzeichnet, daß die Basisbetriebssequenz modifiziert wird, wodurch nach jeder Ausleseperiode (T$_1$) das Ladungspaket für eine vorbestimmte Ladungshalteperiode (T$_2$), unmittelbar vor der entsprechenden Injektionsperiode (T$_3$), zu einem Ladungstopf unter der speichernden Elektrode (2Y) zurücktransferiert wird, und die sequentielle Anwendung der genannten modifizierten Betriebssequenz so gesteuert wird (Figuren 3 und 4), daß der Effekt von Nebensprechen zwischen benachbarten Abbildungselementen nach der Injektion der Ladung in das CID-Substrat während der genannten Injektionsperiode (T$_3$) reduziert wird.

2. Verfahren zum Betrieb einer Ladungsinjektionseinrichtung nach Anspruch 1, dadurch gekennzeichnet, daß die genannte Ladungshalteperiode länger als die Periode ist, die zur Vervollständigung des Auslesebetriebs von wenigstens einem benachbarten Ausleseeinheits-Bildelement erforderlich ist.

3. Verfahren zum Betrieb einer Ladungsinjektions-einrichtung nach Anspruch 1, bei welchem die Bildelement-gruppe, welche die Einheit des Lesebetriebs ist, die Bildelemente einer Reihen- oder Spalteneinheit sind, die gemeinsam angeschlossen sind.

4. Verfahren zum Betrieb einer Ladungsinjektions-einrichtung nach Anspruch 1, bei dem die genannte Ladungshalteperiode bei dem Potentialtopf gerade unter der genannten speichernden Elektrode gegeben ist.

5. Verfahren zum Betrieb einer Ladungsinjektions-einrichtung nach Anspruch 3, bei dem die ladungssensitiven Verstärker entsprechend mit dem Reihenbus verbunden sind, der die fühlenden Elektroden jeder Reihe gemeinsam verbindet, und die Betriebsspannungswellenformen, die aus dem Speichermodus, dem Auslesemodus, dem Ladungshaltemodus und dem Injektionsmodus bestehen, sequentiell wiederholt dem Spaltenbus zugeführt werden, der die speichernden, Elektroden jeder Spalte gemeinsam verbindet, und die Signalladungen in der Einheit der Spaltenrichtung der Bildelementanordnung parallel ausgelesen werden.

6. Verfahren zum Betrieb einer Ladungsinjektionseinrichtung nach Anspruch 5, bei dem die Betriebsspannung, die der fühlenden Elektrode durch den genannten Reihenbus zugeführt wird, periodisch zu hohen und niedrigen Pegeln geändert wird, um den Potentialtopf gerade unter der betreffenden Elektrode verschwinden zu machen, bevor der Ladungsinjektionsmodus für jeden Spaltenbus begonnen wird.

**0 054 455**

Fig. 1
(PRIOR ART)

Fig. 2

**0 054 455**

Fig. 3

3

Fig. 4

0 054 455